# EUROPÄISCHE PATENTANMELDUNG

(11) **EP 0 661 550 A2**
(43) Veröffentlichungstag der Anmeldung: **05.07.1995**
(21) Anmeldenummer: 94120963.7
(22) Anmeldetag: 30.12.1994
(51) Int. Cl.: G01R 31/28

(54) **Verfahren zum Durchführen von Burn-in-Prozeduren an Halbleiterchips**

(30) Priorität: 04.01.1994 DE 4400118
(71) Anmelder: SIEMENS AKTIENGESELLSCHAFT, D-80333 München (DE)
(72) Erfinder: Hübner, Holger, Dr., D-85589 Baldham (DE); Weber, Werner, Dr., D-80637 München (DE)

(57) **Zusammenfassung**

Verfahren zum Durchführen von Burn-in-Testprozeduren an Bauelementen (1) auf der Halbleiterscheibe, auf der sie hergestellt wurden, bei dem für eine temporäre Spannungsversorgung eine strukturierte Metallisierung mit Leiterbahnen (5, 6) und Anschlußflächen (7, 8) aufgebracht wird, mittels dieser Metallisierung die Versorgungsspannung für den Test an die Bauelemente angelegt wird, der Burn-in-Test durchgeführt wird und anschließend die Metallisierung wieder von der Oberfläche der Halbleiterscheibe entfernt wird. Zum Schutz gegen Kurzschlüsse können in den Zuleitungen zwischen dieser Metallisierung und den Anschlußkontakten (2, 3) der einzelnen Bauelemente (1) Verengungen als Schmelzsicherungen (4) ausgebildet sein.

## Beschreibung

Die vorliegende Erfindung betrifft ein Verfahren zum Durchführen von sogenannten Burn-in-Testprozeduren an Halbleiterbauelementen, um eine vorzeitige Alterung dieser Bauelemente zu erreichen und solche mit Frühausfallen aussortieren zu können.

Eines der wesentlichen Hindernisse für eine breitere Anwendung von Multichip-Modulen ist die unzureichende Verfügbarkeit ohne Gehäuse angebotener und billiger Chips mit getesteter Funktionstüchtigkeit Das liegt unter anderem daran, daß üblicherweise Burn-in-Testprozeduren nur an Chips durchgeführt werden, die in einem Gehäuse montiert sind. Bei derartigen Testprozeduren wird das Bauelement hohen Temperaturen und Betriebsspannungen über mehrere Stunden ausgesetzt, um einen künstlichen Alterungsprozeß hervorzurufen. Es ist bekannt, daß der Anteil der Ausfälle während der frühen Betriebsphase besonders hoch ist, während die Ausfallrate später viel kleiner wird. Mit der Burn-in-Prozedur beschleunigt man die frühe Betriebsphase und kann so die fehlerbehafteten Chips durch einen nachfolgenden Funktionstest leicht aussortieren.

Die Burn-in-Testprozeduren dauern zu lange, als daß serielle Methoden angewendet werden könnten, bei denen die Chips nacheinander getestet werden, und zwar solange sie sich noch auf der Halbleiterscheibe (Wafer) befinden, auf der sie hergestellt wurden. Wenn die Chips vereinzelt und im Gehäuse montiert sind, können sie auf einer Steckkarte montiert werden und der Burn-in-Prozedur parallel, d. h. gleichzeitig unterzogen werden. Bei niedrigen Ausbeuten bei diesem Test ist diese Methode teuer, da die Montage des Chips in dem Gehäuse einen erheblichen Aufwand verursacht und eine große Anzahl im Gehäuse montierter Chips im Anschluß an den Test als unbrauchbar verworfen werden muß. Deshalb werden für den Burn-in-Test üblicherweise nur Chips zugelassen, deren Funktion bereits auf dem Wafer vorgetestet ist. Auf diese Weise erreicht man es, die Ausfallrate beim Burn-in-Test in Grenzen zu halten. Es gibt Ansätze, den Burn-in-Test dadurch zu vereinfachen, daß eine temporäre Montage eines Einzelchips in speziell dafür entwickelte Gehäuse durchgeführt wird. Die Durchführung des Test selbst vereinfacht sich dadurch, aber für jedes neu entworfene Bauelement muß ein neues Gehäuse entworfen werden.

Aufgabe der vorliegenden Erfindung ist es, ein Verfahren zur Durchführung von Burn-in-Prozeduren an Halbleiterbauelementen anzugeben, bei dem die sich aus dem Einbau der Chips in Gehäuse ergebenden Schwierigkeiten nicht auftreten und die Testprozedur parallel an mehreren Chips durchgeführt werden kann.

Diese Aufgabe wird mit dem Verfahren mit den Merkmalen des Anspruches 1 gelöst. Weitere Ausgestaltungen ergeben sich aus den abhängigen Ansprüchen.

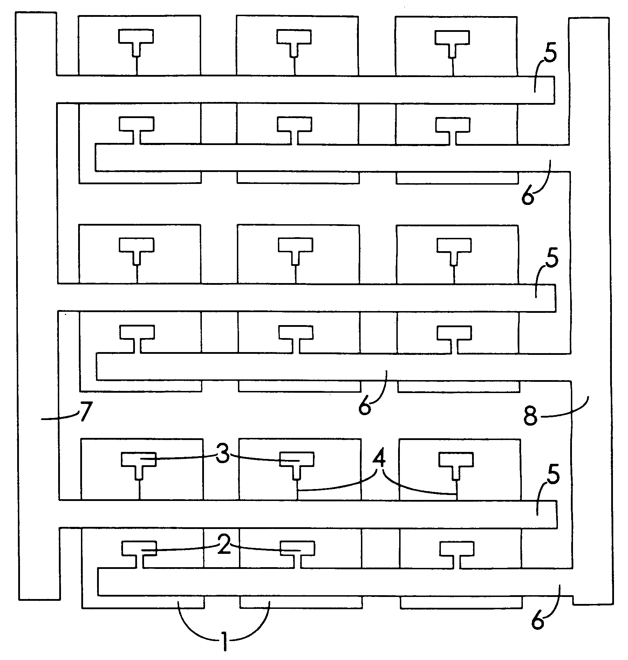

Bei dem erfindungsgemäßen Verfahren wird der Burn-in-Test auf der Halbleiterscheibe (Wafer) durchgeführt, auf der mehrere Bauelemente hergestellt sind. Um alle Chips auf der Scheibe mit der Versorgungsspannung (Anschlüsse Vₛₛ und V_{dd}) verbinden zu können, wird auf der Halbleiterscheibe nach der vollständigen Herstellung der Chips eine Leiterschicht aufgebracht und strukturiert. Da zum Anlegen der Versorgungsspannung die Schaltungen der einzelnen Chips lediglich über zwei Kontakte angeschlossen werden müssen, kann diese Leiterschicht immer kreuzungsfrei in einer einzigen Ebene angeordnet sein. Das kann z. B. wie in der Figur gezeigt durch kammartige Strukturen, die von beiden Seiten ineinandergreifen, realisiert sein.

In der Figur sind die einzelnen Bauelemente 1, die in einer Halbleiterscheibe herstellt wurden, im Schema dargestellt. Auf die Oberseite dieser Bauelemente 1 wird erfindungsgemäß eine Schicht aus elektrisch leitendem Material, z. B. eine Metallisierung, aufgebracht und strukturiert, so daß sie z. B. die in der Figur dargestellte strukturierte Leiterschicht bildet. Die Anschlußflächen 7, 8 sind für den Anschluß der externen Versorgungsspannung vorgesehen. Von diesen Anschlußflächen 7, 8 zweigen jeweils Leiterbahnen 5, 6 ab, die in diesem Ausführungsbeispiel parallel zueinander geführt und gegenüberliegend kammartig verzahnt sind. Diese Leiterbahnen 5, 6 verbinden jeweils eine der Anschlußflächen 7, 8 mit dem einen elektrischen Anschluß jedes Bauelementes 1 aus einer Reihe von hintereinander angeordneten Bauelementen in dem Wafer. Die Leiterbahnen 5, 6 sind so gestaltet, daß bei jedem Bauelement 1 jeweils Abzweigungen zu den Anschlußkontakten 2, 3 für den elektrischen Anschluß der Versorgungsspannung jedes Bauelementes 1 geführt sind.

Da die erfindungsgemäß aufgebrachte Leiterschicht relativ grobe Strukturen aufweisen kann, kann für die Strukturierung z. B. eine im Vergleich zur Herstellung der in den Bauelementen realisierten Funktionselemente grobe Fotolithographie angewendet werden. Bei Bauelementen 1 mit einigen Millimetern Breite können die Leiterbahnen 5, 6 z. B. 1 mm breit sein. Wenn ein Abfall der Versorgungsspannung längs der Halbleiterscheibe um 0,5 V akzeptabel ist und der Stand-by-Strom pro Bauelement 0,5 mA nicht übersteigt, kann man für eine Halbleiterscheibe mit 20 cm Durchmesser und einer Kantenlänge des einzelnen Bauelementes von 2 cm abschätzen, daß das Material der Leiterschicht einen Widerstand nicht über 1 Ω/□ (Ohm/square) haben sollte. Verschiedene Metalle, aber auch Silizide erfüllen diese Anforderung. Unter Umständen ist auch die Verwendung von dotiertem Polysilizium oder leitfähigen Polymeren für die Leiterschicht denkbar. Die für die Lithographie verwendete Schicht kann z. B. Fotolack oder SiO₂ sein und als Isolatorschicht zwischen der Oberseite der Halbleiterscheibe und der erfindungsgemäß aufgebrachten Leiterschicht stehenbleiben.

Ein mögliches Ausführungsbeispiel des erfindungsgemäßen Verfahrens sieht vor, daß zuerst mit einer einfachen Fotolithographie die Kontakte für die Versorgungsspannung der Chips auf dem Wafer geöffnet werden. Die dafür verwendete Fotolackschicht wird nicht entfernt, da sie als Isolatorschicht für die anschließend aufzubringende Leiterschicht dient. Diese Leiterschicht wird als Metallisierung aufgebracht und strukturiert. Da die Feinheit dieser Strukturen und die Ansprüche an die Genauigkeit der Justierung nicht höher sind, als bei den üblichen Verfahren zur Strukturierung auf Boardebene, kann diese Metallisierung z. B. mittels Siebdruck und Verwendung einer leitfähigen Paste aufgebracht werden. Ebenso ist die Abscheidung einer Aluminiumschicht denkbar, die durch eine zweite, grobe Lithographie strukturiert wird. Nach der Durchführung der Burn-in-Testprozedur kann diese Metallisierung abgehoben werden, indem man sie samt der darunterliegenden Isolationsschicht aus Fotolack im Lösungsmittel strippt (lift-off).

Es kann vorkommen, daß ein Bauelement einen Kurzschluß zwischen den Anschlüssen für die Versorgungsspannung hat. In diesem Fall würde ein Spannungsabfall auf der Versorgungsleitung auftreten bzw. die Spannungsversorgung für den gesamten Wafer ausfallen. In jedem Fall wäre ein zuverlässiger Burn-in nicht möglich. Daher ist es ratsam, die Leiterschicht derart zu strukturieren, daß von den Leiterbahnen Abzweigungen zu den Anschlußkontakten 2, 3 der Bauelemente 1 geführt sind und jeweils mindestens eine dieser Zuleitungen mit einer Verengung versehen ist, die als Schmelzsicherung 4 (s. Figur) wirkt. Bei Auftreten eines Kurzschlusses in dem betreffenden Bauelement fließt dann ein so hoher Strom, daß diese Schmelzsicherung 4 durchbrennt und dadurch das betreffende Bauelement von der Spannungsversorgung abgeschnitten wird.

Das Netzteil, das für die Spannungsversorgung verwendet wird, muß dann eine Strombegrenzung aufweisen, deren Wert genügend hoch über der Ansprechschwelle dieser Schmelzsicherungen 4 liegt, so daß volle Betriebsspannung erst erreicht wird, wenn alle Bauelemente mit Kurzschluß von der Versorgungsspannung abgetrennt sind. Um bei einem auftretenden Kurzschluß zu vermeiden, daß über das gemeinsame Substrat alle Chips kurzgeschlossen werden, sind derartige Schmelzsicherungen 4 zumindest in den für den Pluspol vorgesehenen Zuleitungen anzubringen, wenn das Substrat p-leitend dotiert ist. Umgekehrt sind die Schmelzsicherungen in die für den Minuspol vorgesehenen Zuleitungen zu legen, wenn das Substrat n-leitend dotiert ist. Sicherheitshalber können selbstverständlich sämtliche Zuleitungen zu den Anschlußkontakten 2, 3 mit derartigen Schmelzsicherungen 4 versehen werden.

Im Anschluß an den Burn-in-Test kann die Leiterschicht (z. B. die strukturierte Metallisierung) entfernt werden, wobei eine aufgebrachte Isolatorschicht als Lift-off-Schicht dienen kann. Diejenigen Bauelemente, die den Test überstanden haben, können dann vereinzelt und in Gehäusen montiert werden. Diese aufwendige Montage braucht daher nur bei den voll funktionstüchtigen und alterungsbeständigen Chips vorgenommen zu werden.

## Patentansprüche

1. Verfahren zur Durchführung von Burn-in-Testprozeduren an Halbleiterbauelementen,
bei dem zu testende Bauelemente (1) auf einer Halbleiterscheibe, auf der sie gemeinsam hergestellt wurden, mit einer elektrisch leitenden strukturierten Leiterschicht (5, 6, 7, 8) versehen werden und diese Leiterschicht derart strukturiert ist, daß die zum Anlegen einer Versorgungsspannung vorgesehenen Anschlüsse jedes zu testenden Bauelementes (1) über diese Leiterschicht mit einer Versorgungsspannung verbunden werden können, und
bei dem die Burn-in-Testprozedur durchgeführt wird, indem über diese Leiterschicht eine Versorgungsspannung an die auf der Halbleiterscheibe befindlichen zu testenden Bauelemente angelegt wird.

2. Verfahren nach Anspruch 1,
bei dem die Leiterschicht eine kammartige Struktur aufweist, bei der von Anschlußflächen (7, 8) für die Versorgungsspannung jeweils mehrere im wesentlichen parallel zueinander geführte Leiterbahnen (5, 6) abzweigen, die mit jeweils einem Anschlußkontakt (2, 3) mehrerer in Reihe aufeinanderfolgend angeordneter Bauelemente (1) elektrisch leitend verbunden sind.

3. Verfahren nach Anspruch 1 oder 2,
bei dem zumindest in einer der für den Anschluß der Versorgungsspannung vorgesehenen Leiterbahnen (5, 6) für jedes Bauelement (1) gesondert eine Verengung als Schmelzsicherung (4) ausgebildet ist.

4. Verfahren nach Anspruch 3,
bei dem diese Schmelzsicherung (4) in derjenigen Leiterbahn (5) ausgebildet ist, die für den Anschluß desjenigen Poles der Versorgungsspannung vorgesehen ist, dessen Vorzeichen dem Vorzeichen der Leitfähigkeit der Halbleiterscheibe oder eines in der Halbleiterscheibe zur Ausbildung eines Funktionselementes des betreffenden Bauelementes (1) hergestellten dotierten Bereiches (n-Wanne oder p-Wanne) entspricht.

5. Verfahren nach einem der Ansprüche 1 bis 4,
bei dem vor dem Aufbringen der Leiterschicht (5, 6, 7, 8) eine Isolatorschicht aufgebracht und mit Kontaktlöchern an den für den Anschluß der Versorgungsspannung vorgesehenen Stellen der Bauelemente (1) versehen wird und
bei dem die Leiterschicht im Anschluß an die Burn-in-Testprozedur unter Verwendung dieser Isolatorschicht als Lift-off-Schicht abgehoben wird.
